# EUROPEAN PATENT APPLICATION

(11) **EP 4 651 322 A1**
(43) Date of publication of application: **19.11.2025**
(21) Application number: 24210529.4
(22) Date of filing: 04.11.2024
(51) Int. Cl.: H02B 1/56, H05K 7/20

(54) **ELECTRICAL CABINET AND PHOTOVOLTAIC POWER GENERATION SYSTEM**

(30) Priority: 17.05.2024 CN 202421106155 U
(71) Applicant: Sungrow Power Supply Co., Ltd., Hefei, Anhui 230088 (CN)
(72) Inventor: ZHANG, Yayun, Hefei, 230088 (CN); PAN, Hanfei, Hefei, 230088 (CN); ZHANG, Xianwei, Hefei, 230088 (CN)
(74) Representative: Rooney, John-Paul

(57) **Abstract**

An electrical cabinet and a photovoltaic power generation system are provided. The electrical cabinet includes a cabinet body (1) and a heat exchanger (2). The cabinet body (1) is provided with a first switch area (16) and a second switch area (19), which are distributed on adjacent sides of the cabinet body (1). The first switch area (16) is provided with switches (3) distributed along a first direction, and the second switch area (19) is provided with switches (3) distributed along a second direction perpendicular to the first direction. The first switch area (16) and the second switch area (19) are located in a heat dissipation air duct of the cabinet body (1), and are distributed along an airflow direction in the heat dissipation air duct. The heat exchanger (2) can exchange heat with the heat dissipation air duct. The heat dissipation air duct of the electrical cabinet is simplified, improving the heat dissipation effect, and thus improving the heat dissipation capacity of the electrical cabinet.

## Description

### FIELD OF THE INVENTION

The present application relates to the technical field of photovoltaic power generation and, more particularly, to an electrical cabinet and a photovoltaic power generation system.

### BACKGROUND

In photovoltaic power generation systems, an electrical cabinet serves as mid-end equipment between an inverter and a transformer. An electrical cabinet mainly includes a switch and a circuit breaker. The switch is connected to an alternating current (AC) output terminal of an inverter, and then is connected to the circuit breaker to realize the convergence of low-voltage AC power.

With the increasing demand for inverters, the structural design requirements for electrical cabinets are becoming higher and higher. The conventional electrical cabinets have difficulty in meeting the requirements of heat dissipation capacity and maintainability, and in meeting the demands of different power levels.

### SUMMARY

In view of the above, the object of the present application is to provide an electrical cabinet and a photovoltaic power generation system to improve the heat dissipation capacity of the electrical cabinet.

In order to achieve the object, the present application provides the following technical solutions.

An electrical cabinet includes a cabinet body and a heat exchanger; wherein
the cabinet body is provided with a first switch area and a second switch area, the first switch area and the second switch area are distributed on adjacent sides of the cabinet body, the first switch area is provided with switches distributed along a first direction, the second switch area is provided with switches distributed along a second direction, and the first direction is perpendicular to the second direction; and
the first and second switch areas are located in a heat dissipation air duct of the cabinet body, and are distributed along an airflow direction in the heat dissipation air duct; and the heat exchanger is configured to exchange heat with the heat dissipation air duct.

In an embodiment, the switches in the first switch area and the switches in the second switch area are distributed in an L shape.

In an embodiment, an airflow in the heat dissipation air duct flows through the first switch area along the second direction, and the airflow in the heat dissipation air duct flows through the second switch area along the first direction.

In an embodiment, the heat exchanger includes a first heat exchange channel and a second heat exchange channel that are configured to exchange heat with each other, and the heat dissipation air duct and the second heat exchange channel are communicated end to end to form an inner circulation air duct;
the heat dissipation air duct includes a first heat dissipation air duct, a second heat dissipation air duct, a third heat dissipation air duct, and a fourth heat dissipation air duct;
the first heat dissipation air duct, the second heat dissipation air duct, the third heat dissipation air duct, the fourth heat dissipation air duct, and the second heat exchange channel are communicated end to end in sequence; or the third heat dissipation air duct, the second heat dissipation air duct, the first heat dissipation air duct, the fourth heat dissipation air duct, and the second heat exchange channel are communicated end to end in sequence; and
the first switch area is located in the first heat dissipation air duct, and the first heat dissipation air duct is arranged along the second direction; and the second switch area is located in the third heat dissipation air duct, and the third heat dissipation air duct is arranged along the first direction.

In an embodiment, the electrical cabinet further includes a first fan which is configured to drive the airflow to flow from the first switch area to the second switch area, or flow from the second switch area to the first switch area; and/or,
the heat exchanger further includes a second fan which is configured to drive the airflow to flow from the fourth heat dissipation air duct to the second heat exchange channel, or flow from the second heat exchange channel to the fourth heat dissipation air duct.

In an embodiment, the first fan is arranged in the second heat dissipation air duct.

In an embodiment, the fourth heat dissipation air duct includes a first heat-dissipation-air-duct section and a second heat-dissipation-air-duct section in communication with the first heat-dissipation-air-duct section; wherein
the first heat-dissipation-air-duct section and the second heat exchange channel are arranged side by side, and the second heat dissipation air duct and the second heat-dissipation-air-duct section are arranged side by side.

In an embodiment, the electrical cabinet further includes a third fan which is configured to drive the airflow to flow from the first heat-dissipation-air-duct section to the second heat-dissipation-air-duct section, or flow from the second heat-dissipation-air-duct section to the first heat-dissipation-air-duct section.

In an embodiment, the switches in the first switch area and the switches in the second switch area are distributed in a T shape.

In an embodiment, the airflow in the heat dissipation air duct flows through the first switch area and the second switch area in the second direction.

In an embodiment, the heat exchanger includes a first heat exchange channel and a second heat exchange channel that are configured to exchange heat with each other, and the heat dissipation air duct and the second heat exchange channel are communicated end to end to form an inner circulation air duct;
the heat dissipation air duct includes: a sixth heat dissipation air duct, a seventh heat dissipation air duct, and an eighth heat dissipation air duct;
the sixth heat dissipation air duct, the seventh heat dissipation air duct, the eighth heat dissipation air duct, and the second heat exchange channel are communicated end to end in sequence; and
the first switch area and the second switch area are located in the sixth heat dissipation air duct, the sixth heat dissipation air duct and the eighth heat dissipation air duct are arranged along the second direction and distributed side by side, and the seventh heat dissipation air duct and the second heat exchange channel are distributed side by side.

In an embodiment, the electrical cabinet further includes a fourth fan which is configured to drive the airflow to flow from the sixth heat dissipation air duct to the seventh heat dissipation air duct, or flow from the seventh heat dissipation air duct to the sixth heat dissipation air duct; and/or
the electrical cabinet further includes a fifth fan which is configured to drive the airflow to flow from the seventh heat dissipation air duct to the eighth heat dissipation air duct, or flow from the eighth heat dissipation air duct to the seventh heat dissipation air duct; and/or
the heat exchanger further includes a second fan which is configured to drive the airflow to flow from the seventh heat dissipation air duct to the eighth heat dissipation air duct, or flow from the eighth heat dissipation air duct to the seventh heat dissipation air duct.

In an embodiment, the heat exchanger includes a first heat exchange channel and a second heat exchange channel that are configured to exchange heat with each other, and the heat dissipation air duct and the second heat exchange channel are communicated end to end to form an inner circulation air duct.

In an embodiment, a heat dissipation inlet and a heat dissipation outlet of the heat dissipation air duct, and the heat exchanger are distributed on the same side of the cabinet body; and/or
the heat dissipation inlet of the heat dissipation air duct faces the first switch area or the second switch area; and/or
a first cabinet door is provided on a side of the cabinet body that is provided with the first switch area, and a second cabinet door is provided on a side of the cabinet body that is provided with the second switch area; and the heat exchanger is arranged at the first cabinet door or the second cabinet door; and/or
both an inlet and an outlet of the first heat exchange channel are in communication with an external environment of the cabinet body; and the heat exchanger further includes a sixth fan which is configured to drive air in the external environment to flow through the first heat exchange channel.

In an embodiment, the cabinet body is also provided with a circuit breaker area and a power distribution area, wherein the circuit breaker area and the first switch area are located on the same side of the cabinet body, the power distribution area and the second switch area are located on the same side of the cabinet body, and both the circuit breaker area and the power distribution area are located in the heat dissipation air duct; and/or
the cabinet body is also provided with a first wiring area and a second wiring area; the first wiring area and the first switch area are located on the same side of the cabinet body, and the first wiring area and the first switch area are adjacently arranged; and the second wiring area and the second switch area are located on the same side of the cabinet body, and the second wiring area and the second switch area are adjacently arranged.

In an embodiment, the first switch area, the second switch area, the power distribution area, and the circuit breaker area are sequentially distributed along the airflow direction; or the circuit breaker area, the power distribution area, the second switch area, and the first switch area are sequentially distributed along the airflow direction.

In an embodiment, in a case that a first cabinet door is provided on a side of the cabinet body that is provided with the first switch area, and a second cabinet door is provided on a side of the cabinet body that is provided with the second switch area, a tray is provided in the cabinet body, and the tray is located on an inner side of at least one of the first cabinet door and the second cabinet door; wherein
the tray is configured to mount thereon a first device; in a case that the cabinet door corresponding to the tray is opened, the first device is exposed from the cabinet body to enable maintenance of the first device; and/or
a second device is provided in the cabinet body, the second device is located on an inner side of the tray, and the tray is movably arranged in the cabinet body; in a case that the cabinet door corresponding to the tray is opened and the tray is moved to a predetermined position, the second device is exposed from the cabinet body to enable maintenance of the second device.

In an embodiment, the tray is rotatably arranged in the cabinet body; and/or
the second device includes a third fan or a fifth fan, the third fan is configured to drive the airflow in the heat dissipation air duct to flow, and the fifth fan is configured to drive the airflow in the heat dissipation air duct to flow.

Based on the electrical cabinet described above, a photovoltaic power generation system is also provided according to the present application, which includes the electrical cabinet described above.

The heat dissipation principle of the electrical cabinet according to the present application is as follows: since the first and second switch areas are both located in the heat dissipation air duct of the cabinet body and are distributed along the airflow direction in the heat dissipation air duct, the airflow in the heat dissipation air duct flows through the switches in the first and second switch areas, thereby achieving heat dissipation of the switches; the heat exchanger can exchange heat with the heat dissipation air duct, so that the heat exchanger can cool the airflow flowing through the heat dissipation air duct, thereby ensuring the heat dissipation effect of the switches.

In the electrical cabinet according to the present application, the first and second switch areas are distributed on adjacent sides of the cabinet body, wherein the switches distributed along the first direction are arranged in the first switch area, and the switches distributed along the second direction are arranged in the second switch area perpendicular to the first direction. Thus, the distribution of the switches in the first and second switch areas is regulated, thereby ensuring that the heat dissipation airflow flows through the first and second switch areas successively, or through the second and first switch areas successively. Compared with the conventional technology, the heat dissipation air duct is simplified and the heat dissipation effect is improved, thereby improving the heat dissipation capacity of the electrical cabinet and meeting high heat dissipation capacity requirements.

### BRIEF DESCRIPTION OF THE DRAWING

In order to more clearly illustrate the technical solutions in the embodiments of the present application or in the conventional technology, the drawings required in the description of the embodiments or the conventional technologies are briefly introduced below. Apparently, the drawings in the following description are only the embodiments of the present application, and for those skilled in the art, other drawings may also be obtained based on the provided drawings without creative efforts.
FIG. 1 is an axonometric view of a structure of an electrical cabinet according to an embodiment of the present application;
FIG. 2 is an axonometric view of the electrical cabinet shown in FIG. 1 after a first cabinet door is opened;
FIG. 3 is a schematic view of an internal structure on a first side of the electrical cabinet shown in FIG. 1;
FIG. 4 is a schematic view of an internal structure on a second side of the electrical cabinet shown in FIG. 1;
FIG. 5 is a schematic view showing an internal structure and heat dissipation of the electrical cabinet shown in FIG. 1;
FIG. 6 is a schematic view showing heat dissipation of the electrical cabinet shown in FIG. 1;
FIG. 7 is a schematic view showing heat dissipation on the first side of the electrical cabinet shown in FIG. 1;
FIG. 8 is a schematic view showing heat dissipation on the second side of the electrical cabinet shown in FIG. 1;
FIG. 9 is a schematic view of another structure of an electrical cabinet according to another embodiment of the present application;
FIG. 10 is a top view of the electrical cabinet shown in FIG. 9;
FIG. 11 is a schematic view showing heat dissipation of the electrical cabinet shown in FIG. 8;
FIG. 12 is another schematic view showing heat dissipation of the electrical cabinet shown in FIG. 8; and
FIG. 13 is a schematic view of a still another structure of an electrical cabinet according to another embodiment of the present application.

Reference signs in the figures are listed as follows:
1 - cabinet body, 11 - first cabinet door, 12 - second cabinet door, 13 - first side, 14 - second side, 15 - circuit breaker area, 16 - first switch area, 17 - first wiring area, 18 - power distribution area, 19 - second switch area, 110 - second wiring area, 1a - first heat dissipation air duct, 1b - second heat dissipation air duct, 1c - third heat dissipation air duct, 1d - fourth heat dissipation air duct, 11d - first heat-dissipation-air-duct section, 12d - second heat-dissipation-air-duct section, 1f - sixth heat dissipation air duct, 1g - seventh heat dissipation air duct, 1h- eighth heat dissipation air duct, 2 - heat exchanger, 21 - outer air inlet, 22 - outer air outlet, 23 - inner air inlet, 24 - inner air outlet, 2a - first heat exchange channel, 2b - second heat exchange channel, 3 - switch, 31 - load switch, 32 - fuse, 4 - first fan, 5 - third fan, 6 - second fan, 7 - fourth fan, 8 - fifth fan, 9 - sixth fan, 10 - tray.

### DETAIL DESCRIPTION OF EMBODIMENTS

The technical solutions in the embodiments of the present application are clearly and completely described below in conjunction with the drawings. Apparently, the described embodiments are only part of the embodiments of the present application, not all of the embodiments of the present application. Any other embodiment obtained by those skilled in the art based on the embodiments in the present application without creative efforts are within the protection scope of the present application.

The technical solutions in the embodiments of the present application are clearly and completely described below in conjunction with the drawings. The terms used in the embodiments are only for the purpose of describing specific embodiments, and are not intended as limitations to the present application. As used in the specification and appended claims of the present application, singular expressions "a", "an", "said", "the above", "the" and "this" are intended to also include expressions such as "one or more", unless there is a clear contrary indication in the context. It should also be understood that in the embodiments of the present application, "one or more" refers to one, two, or more; "and/or" describes association relationships of associated object, indicating that there may be three relationships, for example, A and/or B may indicate: A exists alone, A and B exist simultaneously, and B exists alone, where A and B may be singular or plural; the character "/" generally indicates that the associated objects before and after the character "/" are in an "or" relationship.

Reference to "an embodiment" or "some embodiments" described in the specification means that specific features, structures, or characteristic described in conjunction with the embodiment are included in one or more embodiments of the present application. Thus, the statements "in an embodiment", "in some embodiments", "in other embodiments", "in some other embodiments", etc. that appear in different places in the specification do not necessarily refer to the same embodiment, but mean reference to "one or more but not all embodiments", unless otherwise specifically emphasized in other ways. The terms "include", "comprise", "have" and their variations mean "include but not limited to", unless otherwise specifically emphasized in other ways.

Multiple involved in the embodiments of the present application indicates greater than or equal to two. It should be noted that in the description of the embodiments of the present application, words such as "first", "second" and the like are only used for the purpose of distinguishing the description, and cannot be understood as indicating or implying relative importance, nor can they be understood as indicating or implying order.

"Parallel" and "perpendicular" involved in the present application are "substantially parallel" and "substantially perpendicular" in actual operation. "Substantially parallel" can be understood as parallel with a certain error, and similarly, "substantially perpendicular" can be understood as perpendicular with a certain error.

An arrow used to indicate a flow direction of airflow in the drawings of the present application is merely illustrative and merely indicates an approximate direction, and does not indicate a unique airflow direction.

An electrical cabinet according to the present application may be an alternating current (AC) electrical cabinet, e.g., a photovoltaic grid-connected low-voltage combiner cabinet, a low-voltage combiner cabinet. The electrical cabinet may be an important component to connect an output of an inverter to an input of an AC distribution cabinet or a step-up transformer, and can collect the alternating current output of multiple inverters and then output the alternating current, greatly simplifying connection lines between the inverters and the AC distribution cabinet or the step-up transformer. The access of the electrical cabinet serves as an output disconnection point of the inverter, which can protect the inverter from harm from an AC power grid, improve the safety of the system, and protect the safety of installation and maintenance personnel.

An electrical cabinet is provided according to an embodiment of the present application, which simplifies the heat dissipation air duct and improves the heat dissipation effect, thereby improving the heat dissipation capacity of the electrical cabinet, and being convenient to meet high demand for heat dissipation capacity.

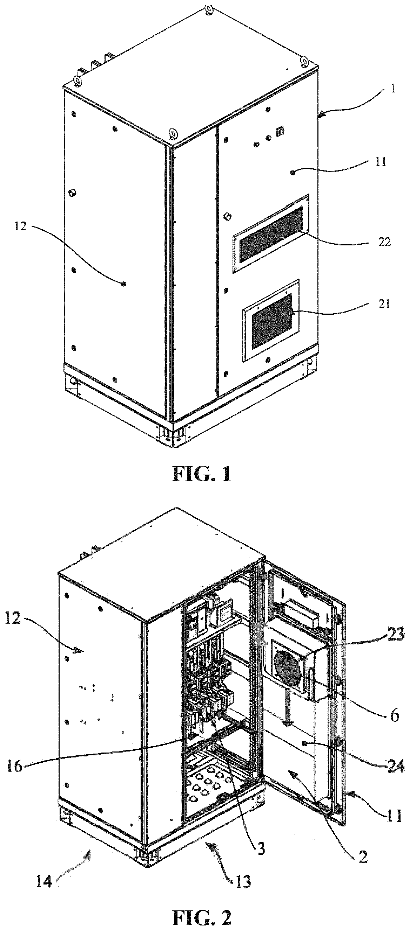

As shown in FIGs. 1 and 2, the electrical cabinet according to the embodiment of the present application includes a cabinet body 1 and a heat exchanger 2.

As shown in FIGs. 2 to 4, the cabinet body 1 is provided with a first switch area 16 and a second switch area 19 distributed on adjacent sides of the cabinet body 1. Exemplarily, a first and second sides 13 and 14 of the cabinet body 1 are adjacent. The first switch area 16 is located on the first side 13 of the cabinet body 1, and the second switch area 19 is located on the second side 14 of the cabinet body 1. Exemplarily, the first side 13 is a front side of the cabinet body 1, and the second side 14 is a left side or a right side of the cabinet body 1.

The first switch area 16 is provided with switches 3 distributed along a first direction, and the second switch area 19 is provided with switches 3 distributed along a second direction perpendicular to the first direction. In order to facilitate the arrangement and operation of the switches 3, the first and second directions may be perpendicular to a vertical direction.

In order to facilitate arrangement of switches 3 in the first switch area 16, the switches 3 are distributed in rows along the first direction and are arranged in at least one row. In a case that the switches 3 are arranged in at least two rows, any two rows of switches 3 are distributed sequentially along the second direction. Correspondingly,, the switches 3 in the second switch area 19 are arranged in rows along the second direction and are arranged in at least one row. In a case that the switches 3 are arranged in at least two rows, any two rows of switches 3 are distributed sequentially along the first direction.

It should be noted that the number of switches 3 in the first switch area 16 may be one or more, and the number of switches 3 in the second switch area 19 may be one or more. The number of rows of switches 3 in the first switch area 16 and the number of rows of switches 3 in the second switch area 19 may be the same or different.

In practical situations, the first direction may be a length direction of the cabinet body 1, and the second direction may be a width direction of the cabinet body 1. Alternatively, the first direction is the width direction of the cabinet body 1, and the second direction is the length direction of the cabinet body 1.

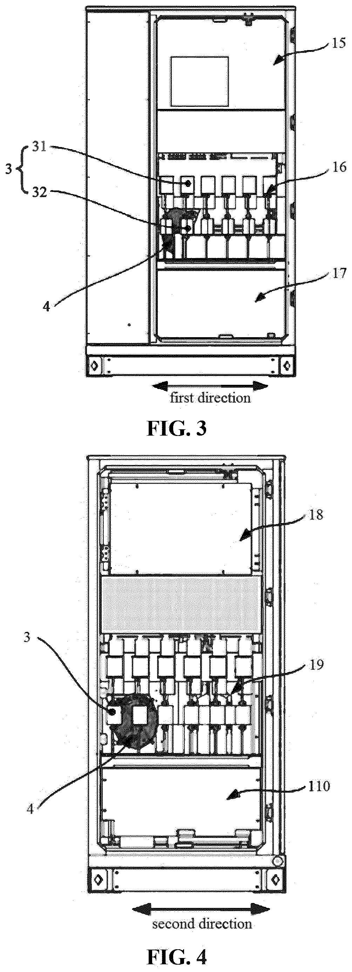

As shown in FIG. 3, the switch 3 includes a load switch 31 and a fuse 32. One end of the fuse 32 is electrically connected to an AC output side of the inverter, and the other end of the fuse 32 is electrically connected to the load switch 31. The switch 3 may be of other structures, which is not limited in the embodiment.

In the embodiment of the present application, the first and second switch areas 16 and 19 are both located in a heat dissipation air duct of the cabinet body 1, and are distributed along an airflow direction in the heat dissipation air duct.

For example, the first and second switch areas 16, 19 are sequentially distributed along the airflow direction in the heat dissipation air duct, that is, a cold air flow firstly flows through the first switch area 16 and then through the second switch area 19. Alternatively, the second and first switch areas 19, 16 are sequentially distributed along the airflow direction in the heat dissipation air duct, that is, the cold air flow firstly flows through the second switch area 19 and then through the first switch area 16.

In an embodiment of the present application, the heat exchanger 2 can exchange heat with the heat dissipation air duct. Exemplarily, the heat exchanger 2 is communicated with the heat dissipation air duct and is configured to cool the airflow flowing through the heat dissipation air duct. The type of the heat exchanger 2 is selected according to the actual situation, which is not limited in the embodiment.

The heat dissipation principle of the electrical cabinet according to the above embodiment is as follows: since the first and second switch areas 16, 19 are both located in the heat dissipation air duct of the cabinet body 1 and are distributed along the air flow direction in the heat dissipation air duct, the airflow in the heat dissipation air duct flows through the switches 3 in the first and second switch areas 16, 19, thereby achieving heat dissipation of the switches 3; and the heat exchanger 2 cools the airflow flowing through the heat dissipation air duct, ensuring the heat dissipation effect of the switches 3.

The above heat dissipation adopts the heat dissipation of heat exchange, instead of the heat dissipation of direct ventilation, improving the IP level of the electrical cabinet.

In the electrical cabinet according to the above embodiment, the first and second switch areas 16, 19 are distributed on adjacent sides of the cabinet body 1, the first switch area 16 being provided with the switches 3 distributed along the first direction, and the second switch area 19 being provided with the switches 3 distributed along the second direction perpendicular to the first direction. Thus, the distribution of the switches 3 in the first and second switch areas 16, 19 is regulated, ensuring that the airflow in the heat dissipation air duct flows through the first switch area 16 and the second switch area 19 successively, or flows through the second switch area 19 and the first switch area 16 successively. Compared with the conventional technology, the heat dissipation air duct is simplified, and the heat dissipation effect is improved, thereby improving the heat dissipation efficiency of the electrical cabinet and meeting the high heat dissipation capacity requirements.

As shown in FIGs. 1 and 2, in order to facilitate the maintenance of the switches 3, a first cabinet door 11 is provided on the first side 13 of the cabinet body 1, and a second cabinet door 12 is provided on the second side of the cabinet body 1. It can be understood that the first cabinet door 11 is arranged on the side of the cabinet body 1 that is provided with the first switch area 16, and the second cabinet door 12 is arranged on the side of the cabinet body 1 that is provided with the second switch area 19.

Each of the first and second cabinet doors 11, 12 can open and close the cabinet body 1. In this way, the switch 3 in the first switch area 16 can be maintained by opening the first cabinet door 11, and the switch 3 in the second switch area 19 can be maintained by opening the second cabinet door 12. Thus, the maintainable operation surface of the electrical cabinet is increased and the maintainability of the electrical cabinet is effectively improved.

As mentioned above, the first switch area 16 is provided with the switches 3 arranged in a row along the first direction, and the second switch area 19 is provided with the switches 3 arranged in a row along the second direction perpendicular to the first direction. In this way, it is convenient to increase or decrease the number of the switches 3, the number of inputs of the switches 3 can be increased or decreased by increasing or decreasing the number of the switches 3, thereby achieving different whole machine powers and meeting the requirements of different power levels. Further, the power density of the entire machine is improved and the later maintenance time is shortened.

In order to facilitate opening and closing of the cabinet body 1, the first and second cabinet doors 11, 12 may be rotatably arranged on the cabinet body 1. For example, the first and second cabinet doors 11, 12 are each rotatably arranged on the cabinet body 1 via a hinge.

In the embodiment of the present application, the cabinet body 1 may also be provided with other cabinet doors, for example, a cabinet door is provided on a side of the cabinet body 1 other than the first and second sides 13, 14. The opening and closing manners of the cabinet doors may be selected according to the actual situation, which is not limited in the embodiment.

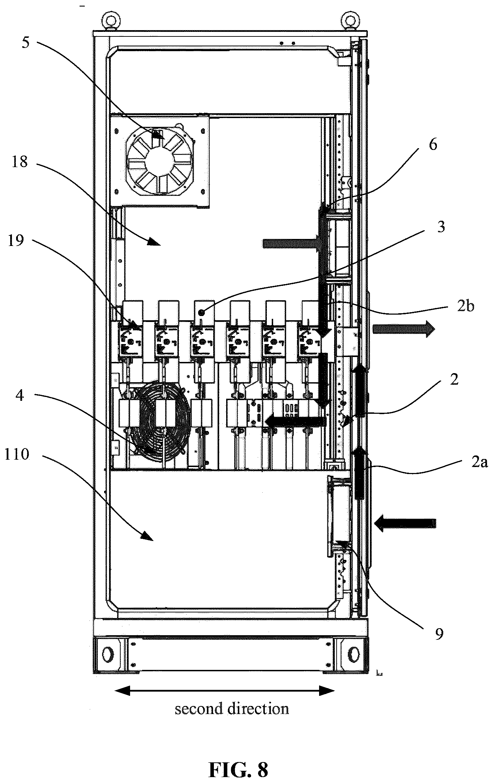

As shown in FIG. 8, in some embodiments, the heat exchanger 2 includes a first heat exchange channel 2a and a second heat exchange channel 2b. The first heat exchange channel 2a is configured to cool the second heat exchange channel 2b, and the second heat exchange channel 2b and the heat dissipation air duct are communicated end to end to form an inner circulation air duct. The first heat exchange channel 2a is configured to cool the second heat exchange channel 2b.

Gas or liquid may flow through the first heat exchange channel 2a, which may be selected according to the actual situation. In order to reduce the cost of heat dissipation, the first heat exchange channel 2a may be configured to communicate with the external environment of the electrical cabinet, that is, both an inlet and an outlet of the first heat exchange channel 2a are in communication with the external environment of the cabinet body 1. In this case, the heat exchanger 2 is an air-to-air heat exchanger. As shown in FIG. 8, in order to improve the heat exchange efficiency, the airflow directions in the first heat exchange channel 2a and the second heat exchange channel 2b may be opposite.

For example, as shown in FIGs. 1 and 2, the heat exchanger 2 has an outer air inlet 21, an outer air outlet 22, an inner air inlet 23, and an inner air outlet 24. In FIG. 2, a vertical arrow indicates a direction of the airflow flowing through the second heat exchange channel 2b, and the other straight arrow in FIG. 2 indicates a direction of the airflow flowing through the first switch area 16.

The outer air inlet 21 and the outer air outlet 22 are in communication with the first heat exchange channel 2a, and the inner air inlet 23 and the inner air outlet 24 are in communication with the second heat exchange channel 2b. The air flows from the external environment into the first heat exchange channel 2a through the outer air inlet 21, and then is discharged to the external environment through the outer air outlet 22. The air in the heat dissipation air duct enters the second heat exchange channel 2b through the inner air inlet 23, and then enters the heat dissipation air duct through the inner air outlet 24.

In some other embodiments, the heat exchanger 2 may be of other structures, which is not limited in the embodiment of the present application.

As shown in FIG. 8, in order to improve the heat dissipation efficiency, the heat exchanger 2 further includes a sixth fan 9, which is configured to drive air from the external environment to flow through the first heat exchange channel 2a.

In order to facilitate the formation of the inner circulation air duct, the heat dissipation inlet and the heat dissipation outlet of the heat dissipation air duct, and the heat exchanger 2 may be distributed on the same side of the cabinet body 1, so that the structure of the heat exchanger 2 is simplified, and the installation of the heat exchanger 2 is also simplified. In this case, the inlet and the outlet of the first heat exchange channel 2a may be in communication with the external environment of the cabinet body 1. The heat exchanger 2 further includes a sixth fan 9, which is configured to drive the air from the external environment to flow through the first heat exchange channel 2a. In this way, it is convenient to form the inner circulation air duct and also convenient to cool the airflow in the inner circulation air duct. The inlet and the outlet of the first heat exchange channel 2a may be in communication with other sources, which is not limited to the above situation.

In the electrical cabinet, the switch 3 generates a large amount of heat and is sensitive to heat. In order to improve the heat dissipation effect of the switch 3, the heat dissipation inlet of the heat dissipation air duct may face the first or second switch area 16, 19. In this case, the type of the heat exchanger 2 is not limited. For example, the inlet and the outlet of the first heat exchange channel 2a may be both in communication with the external environment of the cabinet body 1, and the heat exchanger 2 further includes a sixth fan 9 which is configured to drive the air from the external environment to flow through the first heat exchange channel 2a. In this way, the heat dissipation effect of the switch 3 is improved, and it is convenient to cool the airflow in the inner circulation air duct.

It should be noted that in the case that the heat dissipation inlet is distributed on the first side 13, the heat dissipation inlet faces the first switch area 16; and in the case that the heat dissipation inlet is distributed on the second side 14, the heat dissipation inlet faces the second switch area 19.

The fuse 32 in the switch 3 generates a large amount of heat and has a strong thermal sensitivity. In order to improve the heat dissipation effect, the heat dissipation inlet of the heat dissipation air duct may face the fuse 32 in the first switch area 16 or the fuse 32 in the second switch area 19. In practical situations, the heat dissipation inlet of the heat dissipation air duct may face other components, which is not limited in the embodiment.

In some embodiments, the heat dissipation inlet and the heat dissipation outlet of the heat dissipation air duct, and the heat exchanger 2 may be distributed on the same side of the cabinet body 1, and the heat dissipation inlet of the heat dissipation air duct may face the first switch area 16 or the second switch area 19. In this way, it is convenient to form the inner circulation air duct, and the heat dissipation effect of the switch 3 is improved.

As described above, the cabinet body 1 is provided with the first and second cabinet doors 11, 12. In order to facilitate the installation of the heat exchanger 2, it may be arranged on the first or second cabinet door 11, 12. In this case, the type of the heat exchanger 2 is not limited. For example, the inlet and the outlet of the first heat exchange channel 2a may be communicated with the external environment of the cabinet body 1, and the heat exchanger 2 further includes a sixth fan 9 configured to drive the air from the external environment to flow through the first heat exchange channel 2a, which facilitates installation of the heat exchanger 2 and cooling of the airflow in the inner circulation air duct.

In a case that the heat dissipation inlet and the heat dissipation outlet of the heat dissipation air duct and the heat exchanger 2 are distributed on the same side of the cabinet body 1, the heat dissipation inlet and outlet of the heat dissipation air duct and the heat exchanger 2 may be arranged on the first cabinet door 11, or on the second cabinet door 12.

In a case that the heat dissipation inlet of the heat dissipation air duct faces the first or second switch area 16, 19, the heat exchanger 2 may be arranged on the first cabinet door 11, so that the heat dissipation inlet of the heat dissipation air duct faces the first switch area 16, thereby improving the heat dissipation effect of the switches 3. Alternatively, the heat exchanger 2 may be arranged on the second cabinet door 12, so that the heat dissipation inlet of the heat dissipation air duct faces the second switch area 19, thereby improving the heat dissipation effect of the switches 3.

In a case that the heat dissipation inlet and outlet of the heat dissipation air duct and the heat exchanger 2 are distributed on the same side of the cabinet body 1, and the heat dissipation inlet of the heat dissipation air duct faces the first or second switch area 16, 19, the heat dissipation inlet and outlet of the heat dissipation air duct and the heat exchanger 2 are arranged on the first cabinet door 11 so that the heat dissipation inlet of the heat dissipation air duct faces the first switch area 16, or are arranged on the second cabinet door 12 so that the heat dissipation inlet of the heat dissipation air duct faces the second switch area 19. Thus, it is helpful to install the heat exchanger 2 and improve heat dissipation effect of the switches 3.

As shown in FIGs. 3 to 5, in some embodiments, the switches 3 in the first and second switch areas 16 and 19 may be distributed in an L shape. Based on this, the first and second switch areas 16 and 19 are distributed in an L shape in the cross section of the cabinet body 1, and the cross section is perpendicular to the vertical direction.

In the above embodiment, the airflow in the heat dissipation air duct flows through the first switch area 16 in the second direction, and the airflow in the heat dissipation air duct flows through the second switch area 19 in the first direction, which facilitates the airflow to flow evenly through the switches 3 in the first and second switch areas 16 and 19, thereby improving the heat dissipation uniformity of the first and second switch areas 16 and 19.

In practical situations, the airflow in the heat dissipation air duct may flow through the first and second switch areas 16, 19 in other directions, which is not limited herein.

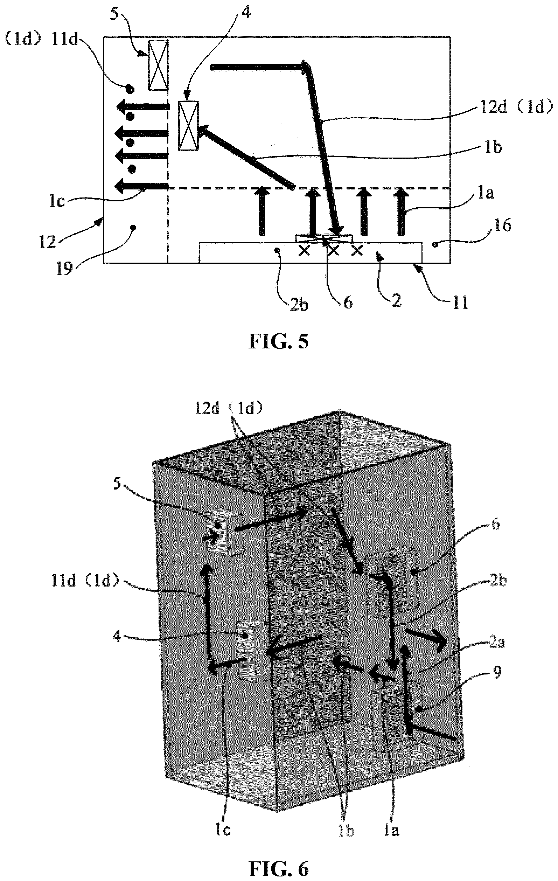

As described above, the second heat exchange channel 2b and the heat dissipation air duct are communicated end to end to form the inner circulation air duct. As shown in FIGs. 5 and 6, in order to facilitate formation of the inner circulation air duct, the heat dissipation air duct includes first to fourth heat dissipation air ducts 1a, 1b, 1c and 1d.

It should be noted that, in order to show the air duct, the first cabinet door 11, the second cabinet door 12, and other electrical components are omitted in FIG. 6.

The first heat dissipation air duct 1a, the second heat dissipation air duct 1b, the third heat dissipation air duct 1c, the fourth heat dissipation air duct 1d and the second heat exchange channel 2b are communicated end to end in sequence. In this case, the second heat exchange channel 2b communicates the first heat dissipation air duct 1a with the fourth heat dissipation air duct 1d, and the heat exchanger 2 is arranged on the first cabinet door 11. Alternatively, the third heat dissipation air duct 1c, the second heat dissipation air duct 1b, the first heat dissipation air duct 1a, the fourth heat dissipation air duct 1d and the second heat exchange channel 2b are communicated end to end in sequence. In this case, the second heat exchange channel 2b communicates the fourth heat dissipation air duct 1d with the third heat dissipation air duct 1c, and the heat exchanger 2 is arranged on the second cabinet door 12.

The first switch area 16 is located in the first heat dissipation air duct 1a arranged along the second direction, so as to ensure that the airflow in the heat dissipation air duct flows through the first switch area 16 in the second direction. The second switch area 19 is located in the third heat dissipation air duct 1c arranged along the first direction, so as to ensure that the airflow in the heat dissipation air duct flows through the second switch area 19 in the first direction.

The above heat dissipation air duct has a simple structure, which is conducive to further improving the heat dissipation effect.

In the case that the second heat exchange channel 2b communicates the first heat dissipation air duct 1a with the fourth heat dissipation air duct 1d, the inlet of one of the first and fourth heat dissipation air ducts 1a, 1d is the heat dissipation inlet of the heat dissipation air duct, and the outlet of the other of the first and fourth heat dissipation air ducts 1a, 1d is the heat dissipation outlet of the heat dissipation air duct. In a case that the inlet of the first heat dissipation air duct 1a is the heat dissipation inlet of the heat dissipation air duct, the airflow in the heat dissipation air duct firstly flows through the switches 3 in the first and second switch areas 16, 19, improving the heat dissipation effect of the switches 3.

In a case that the second heat exchange channel 2b communicates the fourth heat dissipation air duct 1d with the third heat dissipation air duct 1c, the inlet of one of the third and fourth heat dissipation air ducts 1c, 1d is the heat dissipation inlet of the heat dissipation air duct, and the outlet of the other of the third and fourth heat dissipation air ducts 1c, 1d is the heat dissipation outlet of the heat dissipation air duct. In a case that the inlet of the third heat dissipation air duct 1c is the heat dissipation inlet of the heat dissipation air duct, the airflow in the heat dissipation air duct firstly flows through the switches 3 in the first and second switch areas 16 and 19, improving the heat dissipation effect of the switches 3.

In a case that the inner circulation air duct has a bend, in order to facilitate the circulation of the airflow, the electrical cabinet further includes a first fan 4, and/or the heat exchanger 2 further includes a second fan 6. For example, the electrical cabinet may further include the first fan 4, or the heat exchanger 2 may further include the second fan 6; or the electrical cabinet may further include the first fan 4 and the heat exchanger 2 may further include the second fan 6.

The first fan 4 is configured to drive the airflow to flow from the first switch area 16 to the second switch area 19, or flow from the second switch area 19 to the first switch area 16, so as to facilitate the airflow to flow through the first switch area 16 and the second switch area 19, thereby facilitating the circulation of the airflow in the inner circulation air duct.

For the convenience of driving the airflow, the first fan 4 may be arranged at a position where the second heat dissipation air duct 1b and the third heat dissipation air duct 1c are communicated. In order to avoid the first fan 4 interfering with the arrangement of the switches 3, the first fan 4 may be arranged in the second heat dissipation air duct 1b. In an embodiment, the first fan 4 may be arranged in the first, second or third heat dissipation air duct 1a, 1b or 1c, which is not limited to the above-mentioned manner.

The first fan 4 may be a turbulence fan to improve the turbulence effect. The first fan 4 may also be a centrifugal fan or an axial fan. The type of first fan 4 may be selected according to the actual situation and is not limited in the embodiment.

The second fan 6 is configured to drive the airflow to flow from the fourth heat dissipation air duct 1d to the second heat exchange channel 2b, or flow from the second heat exchange channel 2b to the fourth heat dissipation air duct 1d. In this way, it is convenient for the airflow to flow through the first switch area 16 and the second switch area 19, thereby facilitating the circulation of the airflow in the inner circulation air duct.

In order to facilitate driving of the airflow, the second fan 6 is arranged at a position where the fourth heat dissipation air duct 1d and the second heat exchange channel 2b are communicated. Further, the second fan 6 is arranged in the second heat exchange channel 2b.

The second fan 6 may be a turbulence fan to improve the turbulence effect. The second fan 6 may also be a centrifugal fan or an axial fan. The type of second fan 6 may be selected according to the actual situation and is not limited in the embodiment.

It should be noted that, in the case that the second heat exchange channel 2b communicates the first heat dissipation air duct 1a with the fourth heat dissipation air duct 1d and the inlet of the first heat dissipation air duct 1a is the heat dissipation inlet of the heat dissipation air duct, the first fan 4 is configured to drive the airflow to flow from the first switch area 16 to the second switch area 19, and the second fan 6 is configured to drive the airflow to flow from the fourth heat dissipation air duct 1d to the second heat exchange channel 2b. In the case that the second heat exchange channel 2b communicates the third heat dissipation air duct 1c with the fourth heat dissipation air duct 1d and the inlet of the third heat dissipation air duct 1c is the heat dissipation inlet of the heat dissipation air duct, the first fan 4 is configured to drive the airflow to flow from the second switch area 19 to the first switch area 16, and the second fan 6 is configured to drive the airflow to flow from the second heat exchange channel 2b to the fourth heat dissipation air duct 1d.

In practical applications, a fan may be provided at a position where the third heat dissipation air duct 1c and the fourth heat dissipation air duct 1d are communicated, or may be provided at another place, which is not limited to the first fan 4 and the second fan 6.

As described above, the cabinet body 1 is provided with the first cabinet door 11 and the second cabinet door 12. In order to facilitate the installation of the second fan 6, the second fan 6 may be arranged on the second cabinet door 12 or the first cabinet door 11.

It should be noted that the second fan 6 is part of the heat exchanger 2; In a case that the heat exchanger 2 is located at the first cabinet door 11, the second fan 6 is located at the first cabinet door 11; In a case that the heat exchanger 2 is arranged on the second cabinet door 12, the second fan 6 is arranged on the second cabinet door 12.

In order to facilitate the arrangement of the fourth heat dissipation air duct 1d, the fourth heat dissipation air duct 1d may include a first heat-dissipation-air-duct section 11d, and a second heat-dissipation-air-duct section 12d communicated with the first heat-dissipation-air-duct section 11d. The first heat-dissipation-air-duct section 11d and the second heat exchange channel 2b are arranged in parallel, and the second heat dissipation air duct 1b and the second heat-dissipation-air-duct section 12d are arranged in parallel. Further, the second heat dissipation air duct 1b and the second heat-dissipation-air-duct section 12d may be arranged in sequence in the vertical direction.

It should be noted that, in the case that the first to fourth heat dissipation air ducts 1a, 1b, 1c, 1d, and the second heat exchange channel 2b are communicated end to end in sequence, the first to third heat dissipation air ducts 1a, 1b, 1c, the first and second heat-dissipation-air-duct sections 11d, 12d, and the second heat exchange channel 2b are communicated end to end in sequence. In the case that the third heat dissipation air duct 1c, the second heat dissipation air duct 1b, the first heat dissipation air duct 1a, the fourth heat dissipation air duct 1d, and the second heat exchange channel 2b are communicated end to end in sequence, the third heat dissipation air duct 1c, the second heat dissipation air duct 1b, the first heat dissipation air duct 1a, the second heat-dissipation-air-duct section 12d, the first heat-dissipation-air-duct section 11d, and the second heat exchange channel 2b are communicated end to end in sequence.

In order to facilitate flow of the airflow, the electrical cabinet further includes a third fan 5 which is configured to drive the airflow to flow from the first heat-dissipation-air-duct section 11d to the second heat-dissipation-air-duct section 12d, or flow from the second heat-dissipation-air-duct section 12d to the first heat-dissipation-air-duct section 11d.

It should be noted that, in the case that the first to fourth heat dissipation air ducts 1a, 1b, 1c, 1d, and the second heat exchange channel 2b are communicated end to end in sequence, the third fan 5 is configured to drive the airflow to flow from the first heat-dissipation-air-duct section 11d to the second heat-dissipation-air-duct section 12d. In the case that the third, second, first and fourth heat dissipation air ducts 1c, 1b, 1a, 1d, and the second heat exchange channel 2b are communicated end to end in sequence, the third fan 5 is configured to drive the airflow to flow from the second heat-dissipation-air-duct section 12d to the first heat-dissipation-air-duct section 11d.

In order to facilitate the driving of the airflow, the third fan 5 is arranged at a position where the first and second heat-dissipation-air-duct sections 11d, 12d are communicated. In order to facilitate the airflow in the third heat dissipation air duct 1c to flow towards the fourth heat dissipation air duct 1d, or to facilitate the airflow in the fourth heat dissipation air duct 1d to flow towards the third heat dissipation air duct 1c, the third fan 5 may be arranged in first heat-dissipation-air-duct section 11d. Thus, there is no need to provide a fan at a position where the third and fourth heat dissipation air ducts 1c, 1d are communicated, the number and cost of fans can be reduced, and the structure of the electrical cabinet can be simplified.

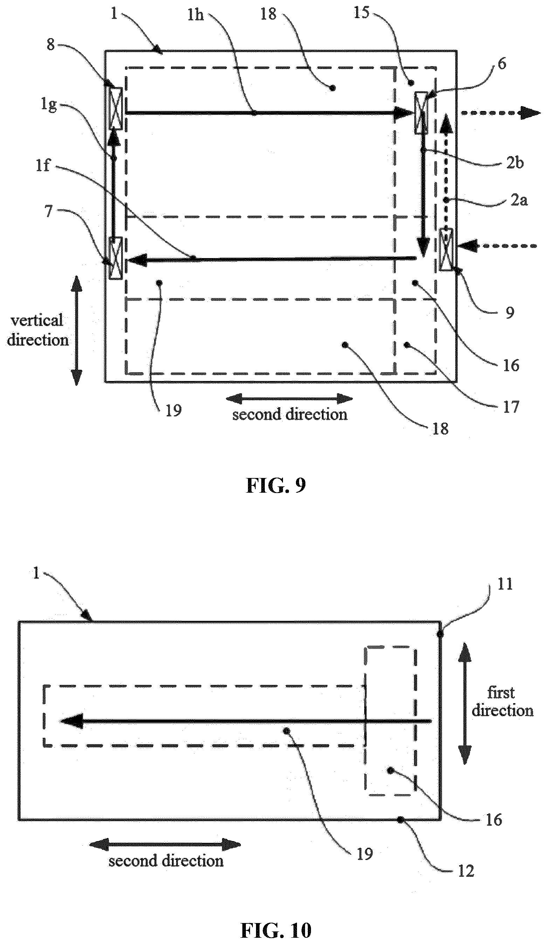

The third fan 5 may be a turbulence fan to improve the turbulence effect. The third fan 5 may also be a centrifugal fan or an axial fan. The type of the third fan 5 may be selected according to actual conditions and is not limited in the embodiment. As shown in FIGs. 9 and 10, in some other embodiments, the switches 3 in the first and second switch areas 16, 19 may be arranged in a T shape. Based on this, the first and second switch areas 16, 19 may be arranged in a T shape.

It should be noted that FIG. 10 is a top view of the electrical cabinet shown in FIG. 9, and a circuit breaker area 15, a power distribution area 18, a first wiring area 17, and a second wiring area 110 mentioned later are not shown in FIG. 10.

In the above embodiment, the airflow in the heat dissipation air duct flows through the first and second switch areas 16, 19 in the second direction, so that the airflow can flow evenly through the switches 3 in the first and second switch areas 16, 19, thereby improving the heat dissipation uniformity of the first and second switch areas 16, 19.

In practical situations, the airflow in the heat dissipation air duct may flow through the first and second switch areas 16, 19 in other directions, which is not limited herein.

As described above, the second heat exchange channel 2b and the heat dissipation air duct are communicated end to end to form the inner circulation air duct. As shown in FIGs. 9 to 12, in order to facilitate the formation of the inner circulation air duct, the heat dissipation air duct includes sixth, seventh and eighth heat dissipation air ducts 1f, 1g and 1h.

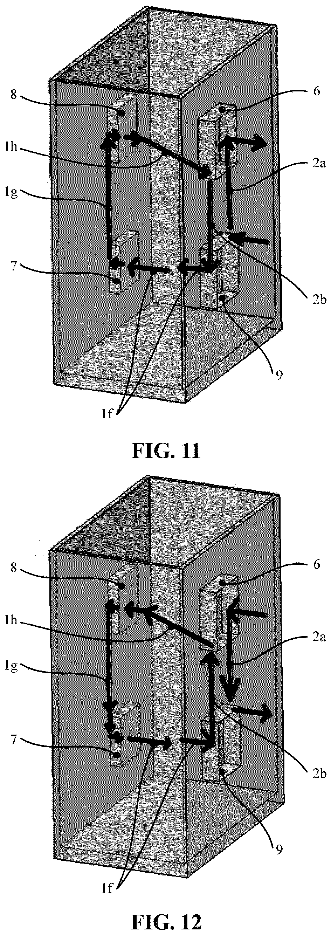

It should be noted that, in order to show the airflow direction, the first and second cabinet doors 11, 12 and other electrical components are omitted in FIGs. 11 and 12.

The sixth to eighth heat dissipation air ducts 1f, 1g, 1h, and the second heat exchange channel 2b are communicated end to end in sequence.

The first and second switch areas 16, 19 are located in the sixth heat dissipation air duct 1f arranged along the second direction to ensure that the airflow in the heat dissipation air duct flows through the first and second switch areas 16, 19 in the second direction.

The sixth and eighth heat dissipation air ducts 1f and 1h are arranged in parallel, that is, the eighth heat dissipation air duct 1h is also arranged along the second direction, and the seventh heat dissipation air duct 1g and the second heat exchange channel 2b are arranged in parallel.

The inlet of one of the sixth and eighth heat dissipation air ducts 1f and 1h is the heat dissipation inlet of the heat dissipation air duct, and the outlet of the other of the sixth and eighth heat dissipation air ducts 1f and 1h is the heat dissipation outlet of the heat dissipation air duct. As shown in FIGs. 9 to 11, the inlet of the sixth heat dissipation air duct 1f is the heat dissipation inlet of the heat dissipation air duct, and the outlet of the eighth heat dissipation air duct 1h is the heat dissipation outlet of the heat dissipation air duct. As shown in FIG. 12, the inlet of the eighth heat dissipation air duct 1h is the heat dissipation inlet of the heat dissipation air duct, and the outlet of the sixth heat dissipation air duct 1f is the heat dissipation outlet of the heat dissipation air duct.

In the case that the inlet of the sixth heat dissipation air duct 1f is the heat dissipation inlet of the heat dissipation air duct, as shown in FIGs. 9 to 11, the airflow in the heat dissipation air duct firstly flows through the switches 3 in the first switch area 16 and in the second switch area 19, thereby improving the heat dissipation effect on the switches 3.

In the case that the inlet of the sixth heat dissipation air duct 1f is the heat dissipation inlet of the heat dissipation air duct, the first switch area 16 is close to the inlet of the sixth heat dissipation air duct 1f if the heat exchanger 2 is arranged on the first cabinet door 11; the second switch area 19 is close to the inlet of the sixth heat dissipation air duct 1f if the heat exchanger 2 is arranged on the second cabinet door 12.

The above heat dissipation air duct has a simple structure, which further improves the heat dissipation effect.

In order to facilitate the arrangement of the sixth and eighth heat dissipation air ducts 1f and 1h, the sixth and eighth heat dissipation air ducts 1f and 1h may be arranged in sequence along the vertical direction. Exemplarily, the sixth heat dissipation air duct 1f is lower than the eighth heat dissipation air duct 1h, and the sixth and eighth heat dissipation air ducts 1f and 1h are each arranged in the horizontal direction. Alternatively, the sixth heat dissipation air duct 1f is higher than the eighth heat dissipation air duct 1h, and the sixth and eighth heat dissipation air ducts 1f and 1h are each arranged in the horizontal direction. The sixth and eighth heat dissipation air ducts 1f and 1h may also be distributed in other directions, which is not limited in the embodiment.

In a case that the inner circulation air duct has a bend, in order to facilitate the circulation of the airflow, the electrical cabinet further includes a fourth fan 7 and/or a fifth fan 8, and/or the heat exchanger 2 further includes a second fan 6. Exemplarily, the electrical cabinet further includes a fourth fan 7 or a fifth fan 8, or the heat exchanger 2 further includes a second fan 6; the electrical cabinet further includes a fourth fan 7 and a fifth fan; the electrical cabinet further includes a fifth fan 8 and the heat exchanger 2 further includes a second fan 6; the electrical cabinet further includes a fourth fan 7 and the heat exchanger 2 further includes a second fan 6; or the electrical cabinet further includes a fourth fan 7 and a fifth fan 8, and the heat exchanger 2 further includes a second fan 6.

The fourth fan 7 is configured to drive the airflow to flow from the sixth heat dissipation air duct 1f to the seventh heat dissipation air duct 1g, or flow from the seventh heat dissipation air duct 1g to the sixth heat dissipation air duct 1f. In this way, it is convenient for the airflow to flow through the sixth and seventh heat dissipation air ducts 1f and 1g, thereby facilitating flow of the air in the inner circulation air duct.

For the convenience of driving the airflow, the fourth fan 7 may be arranged at a position where the sixth and seventh heat dissipation air ducts 1f and 1g are communicated. In order to avoid the fourth fan 7 interfering with the arrangement of the switches 3, the fourth fan 7 may be arranged in the seventh heat dissipation air duct 1g.

The fifth fan 8 is configured to drive the airflow to flow from the seventh heat dissipation air duct 1g to the eighth heat dissipation air duct 1h, or flow from the eighth heat dissipation air duct 1h to the seventh heat dissipation air duct 1g. In this way, it is convenient for the airflow to flow through the eighth and seventh heat dissipation air ducts 1h and 1g, thus facilitating the airflow to flow in the inner circulation air duct.

For the convenience of driving the airflow, the fifth fan 8 may be arranged at a position where the eighth and seventh heat dissipation air ducts 1h and 1g are communicated. In order to prevent the fifth fan 8 from interfering with the installation of other components, the fifth fan 8 may be disposed in the seventh heat dissipation air duct 1g.

The second fan 6 is configured to drive the airflow to flow from the eighth heat dissipation air duct 1h to the second heat exchange channel 2b, or flow from the second heat exchange channel 2b to the eighth heat dissipation air duct 1h, so that the airflow easily flows through the eighth heat dissipation air duct 1h and the second heat exchange channel 2b, thereby facilitating flow of air in the inner circulation air duct.

In order to facilitate driving the airflow, the second fan 6 is arranged at a position where the eighth heat dissipation air duct 1h and the second heat exchange channel 2b are communicated. Further, the second fan 6 is arranged in the second heat exchange channel 2b.

The second fan 6 may be a turbulence fan to improve the turbulence effect. The second fan 6 may also be a centrifugal fan or an axial fan. The type of the second fan 6 may be selected according to actual conditions and is not limited in the embodiment.

It should be noted that, in a case that the fourth fan 7 is configured to drive the airflow to flow from the sixth heat dissipation air duct 1f to the seventh heat dissipation air duct 1g, as shown in FIGs. 9 to 11, the fifth fan 8 is configured to drive the airflow to flow from the seventh heat dissipation air duct 1g to the eighth heat dissipation air duct 1h, and the second fan 6 is configured to drive the airflow to flow from the eighth heat dissipation air duct 1h to the second heat exchange channel 2b. In this case, under the action of the fourth fan 7, the airflow in the second heat exchange channel 2b enters the sixth heat dissipation air duct 1f, and the airflow in the sixth heat dissipation air duct 1f enters the seventh heat dissipation air duct 1g; under the action of the fifth fan 8, the airflow in the seventh heat dissipation air duct 1g enters the eighth heat dissipation air duct 1h; under the action of the second fan 6, the airflow in the eighth heat dissipation air duct 1h enters the second heat exchange channel 2b.

In a case that the fourth fan 7 is configured to drive the airflow to flow from the seventh heat dissipation air duct 1g to the sixth heat dissipation air duct 1f, as shown in FIG. 12, the second fan 6 is configured to drive the airflow to flow from the second heat exchange channel 2b to the eighth heat dissipation air duct 1h, and the fifth fan 8 is configured to drive the airflow to flow from the eighth heat dissipation air duct 1h to the seventh heat dissipation air duct 1g. In this case, the airflow in the second heat exchange channel 2b enters the eighth heat dissipation air duct 1h under the action of the second fan 6; the airflow in the eighth heat dissipation air duct 1h enters the seventh heat dissipation air duct 1g under the action of the fifth fan 8; and the airflow in the seventh heat dissipation air duct 1g enters the sixth heat dissipation air duct 1f and the second heat exchange channel 2b under the action of the fourth fan 7.

As described above, the cabinet body 1 is provided with the first cabinet door 11 and the second cabinet door 12. For the convenience of installation and maintenance, the heat exchanger 2 is arranged on the first cabinet door 11, and the fourth fan 7 and the fifth fan 8 are arranged on a cabinet door opposite to the first cabinet door 11. Alternatively, the heat exchanger 2 is arranged on the second cabinet door 12, and the fourth fan 7 and the fifth fan 8 are arranged on a cabinet door opposite to the second cabinet door 12. It should be noted that the fourth fan 7 and the heat exchanger 2 are respectively arranged on two opposite cabinet doors, and the fifth fan 8 and the heat exchanger 2 are respectively arranged on two opposite cabinet doors.

The types of the fourth fan 7 and the fifth fan 8 may selected according to the actual situation, which is not limited in the embodiment. The description of the second fan 6 may be referred to the above and is not repeated here.

In practical applications, other fans may also be arranged at other locations of the inner circulation air duct, which is not limited to the fourth fan 7, the fifth fan 8, and the second fan 6 mentioned above.

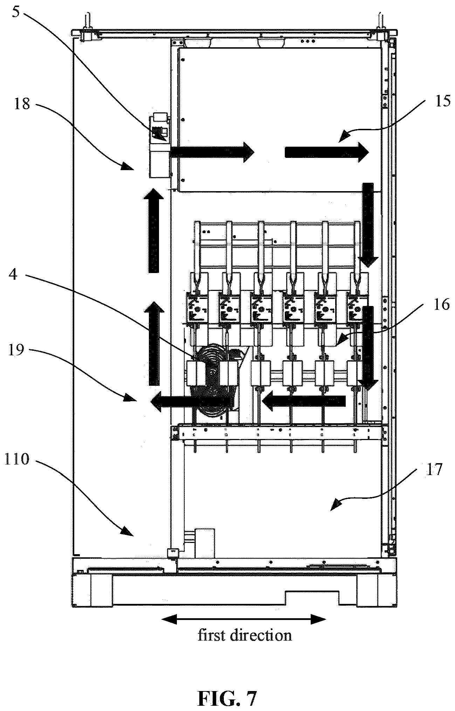

In an embodiment of the present application, the electrical cabinet further includes a circuit breaker and a power distribution module. As shown in FIGs. 3, 4, 7, 8 and 9, in some embodiments, the cabinet body 1 is also provided with a circuit breaker area 15 and a power distribution area 18. The circuit breaker area 15 is configured for arrangement of the circuit breaker, and the power distribution area 18 is configured for arrangement of the power distribution module. The circuit breaker area 15 and the first switch area 16 are located on the same side of the cabinet body 1, and the power distribution area 18 and the second switch area 19 are located on the same side of the cabinet body 1.

As described above, the first and second switch areas 16 and 19 may be distributed in an L shape in the cross section of the cabinet body 1. Based on this, the circuit breaker area 15 and the power distribution area 18 may be distributed in an L shape in the cross section of the cabinet body 1.

As described above, the first and second switch areas 16 and 19 may be distributed in a T shape in the cross section of the cabinet body 1. Based on this, the circuit breaker area 15 and the power distribution area 18 may be distributed in a T shaped in the cross section of the cabinet body 1.

It should be noted that the circuit breaker area 15 does not include the devices arranged in the circuit breaker area 15, and the power distribution area 18 does not include devices arranged in the power distribution area 18.

For the convenience of wiring, the circuit breaker area 15 and the first switch area 16 may be arranged in sequence along the vertical direction, and the power distribution area 18 and the second switch area 19 may be arranged in sequence along the vertical direction.

For example, the circuit breaker area 15 is located on a top side of the first switch area 16, and the power distribution area 18 is located on a top side of the second switch area 19. Alternatively, the circuit breaker area 15 is located on a bottom side of the first switch area 16, and the power distribution area 18 is located on a bottom side of the second switch area 19.

The circuit breaker area 15 and the power distribution area 18 are located in the heat dissipation air duct, so that the first switch area 16, the second switch area 19, the circuit breaker area 15, and the power distribution area 18 are distributed along the airflow direction in the heat dissipation air duct in a predetermined order, thereby achieving heat dissipation of the circuit breaker and the power distribution module.

In a case that the heat dissipation air duct includes the first to fourth heat dissipation air ducts 1a, 1b, 1c and 1d, and the fourth heat dissipation air duct 1d includes the first heat-dissipation-air-duct section 11d and the second heat-dissipation-air-duct section 12d, the power distribution area 18 is located in the first heat-dissipation-air-duct section 11d, and the circuit breaker area 15 is located in the second heat-dissipation-air-duct section 12d. In this case, the circuit breaker area 15 is located on the top side of the first switch area 16, and the power distribution area 18 is located on the top side of the second switch area 19, and the second heat-dissipation-air-duct section 12d is located on the top of the second heat dissipation air duct 1b.

In a case that the heat dissipation air duct includes the sixth to eighth heat dissipation air ducts 1f, 1g and 1h, the power distribution area 18 and the circuit breaker area 15 are both located in the eighth heat dissipation air duct 1h.

As shown in FIGs. 5 to 8, in some embodiments, the first switch area 16, the second switch area 19, the power distribution area 18 and the circuit breaker area 15 may be distributed in sequence along the airflow direction. Since the switch 3 generates a large amount of heat and is sensitive to heat, the switch 3 may be cooled firstly, and then the power distribution module and the circuit breaker may be cooled, thereby improving the heat dissipation effect.

In other embodiments, the circuit breaker area 15, the power distribution area 18, the second switch area 19 and the first switch area 16 may be distributed in sequence along the airflow direction.

A heat dissipation manner of the electrical cabinet is described below with reference to FIGs. 5 to 8. The airflow cooled by the heat exchanger 2 enters the first heat dissipation air duct 1a, flows through the first switch area 16 in the first heat dissipation air duct 1a, enters the second heat dissipation air duct 1b, and then is directed to the third heat dissipation air duct 1c by the first fan 4. After the airflow flows through the second switch area 19 in the third heat dissipation air duct 1c, the airflow flows to the first heat-dissipation-air-duct section 11d of the fourth heat dissipation air duct 1d under the action of the third fan 5. After the airflow flows through the power distribution area 18 in the first heat-dissipation-air-duct section 11d, the airflow continues to flow and enters the second heat-dissipation-air-duct section 12d under the action of the third fan 5. The airflow flows through the circuit breaker area 15 in the second heat-dissipation-air-duct section 12d, and under the action of the second fan 6, the airflow enters the second heat exchange channel 2b from the second heat-dissipation-air-duct section 12d. The airflow flowing through the second heat exchange channel 2b is cooled by the airflow flowing through the first heat exchange channel 2a, and then enters the first heat dissipation air duct 1a. The circulation is repeated.

It should be noted that, in FIG. 5, "×" indicates a direction perpendicular to a paper surface and oriented inwardly, and "•" indicates a direction perpendicular to the paper surface and oriented outwardly.

Another heat dissipation manner of the electrical cabinet is described below with reference to FIGs. 9 to 11. The airflow cooled by the heat exchanger 2 enters the sixth heat dissipation air duct 1f. After the airflow flows through the first and second switch areas 16 and 19 in the sixth heat dissipation air duct 1f, and the airflow enters the seventh heat dissipation air duct 1g under the action of the fourth fan 7. The airflow enters the eighth heat dissipation air duct 1h from the seventh heat dissipation air duct 1g under the action of the fifth fan 8. The airflow flows through the power distribution area 18 and the circuit breaker area 15 in the eighth heat dissipation air duct 1h, and then enters the second heat exchange channel 2b. The airflow flowing through the second heat exchange channel 2b is cooled by the airflow flowing through the first heat exchange channel 2a, and then enters the first heat dissipation air duct 1a. The circulation is repeated.

Another heat dissipation manner of the electrical cabinet is described below with reference to FIG. 12. The airflow cooled by the heat exchanger 2 enters the eighth heat dissipation air duct 1h. After flowing through the circuit breaker area 15 and the power distribution area 18 in the eighth heat dissipation air duct 1h, the airflow enters the seventh heat dissipation air duct 1g under the action of the fifth fan 8. The airflow enters the sixth heat dissipation air duct 1f from the seventh heat dissipation air duct 1g under the action of the fourth fan 7. The airflow flows through the second switch area 19 and the first switch area 16 in the sixth heat dissipation air duct 1f, and then enters the second heat exchange duct 2b. The airflow flowing through the second heat exchange duct 2b is cooled by the airflow flowing through the first heat exchange duct 2a, and then enters the eighth heat dissipation air duct 1h. The circulation is repeated.

As shown in FIGs. 3, 4, 7, 8 and 9, in order to facilitate wiring, the cabinet body 1 is also provided with a first wiring area 17 and a second wiring area 110. The first wiring area 17 and the first switch area 16 are located on the same side of the cabinet body, and are adjacently arranged. The second wiring area 110 and the second switch area 19 are located on the same side of the cabinet body 1, and are adjacently arranged.

In practical situations, the cabinet body 1 may be provided with a circuit breaker area 15 and a power distribution area 18, and may be not provided with a first and second wiring areas 17 and 110; the cabinet body 1 may be provided with a first and second wiring areas 17 and 110, and may be not provided with a circuit breaker area 15 and a power distribution area 18; or the cabinet body 1 may be provided with a circuit breaker area 15, a power distribution area 18, and a first and second wiring areas 17 and 110.

It should be noted that, in a case that the cabinet body 1 is provided with the circuit breaker area 15, the power distribution area 18, and the first and second wiring areas 17 and 110, the entire cabinet body 1 is divided into areas, so that the internal structure of the cabinet body 1 is simply, facilitating the installation of the components inside the cabinet body 1.

In some embodiments, the cabinet body 1 is provided with a circuit breaker area 15, a power distribution area 18, and first and second wiring areas 17 and 110. The circuit breaker area 15 may be located on the top side of the first switch area 16; the power distribution area 18 may be located on the top side of the second switch area 19; the first wiring area 17 may be located on the bottom side of the first switch area 16, and the second wiring area 110 may be located on the bottom side of the second switch area 19.

If the first switch area 16 and the second switch area are distributed in an L shape in the cross section of the cabinet body 1, the first and second wiring areas 17 and 110 are distributed in an L shape in the cross section of the cabinet body 1. If the first switch area 16 and the second switch area are distributed in a T shape in the cross section of the cabinet body 1, the first and second wiring areas 17 and 110 are distributed in a T shape in the cross section of the cabinet body 1.

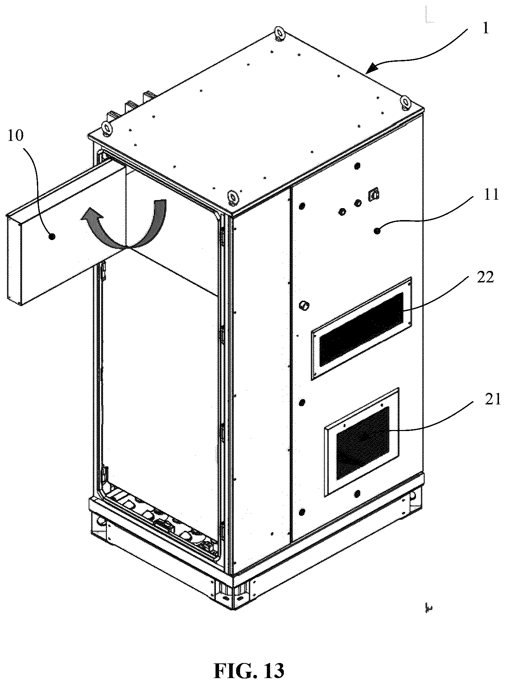

As shown in FIG. 13, in some embodiments, a tray 10 is provided in the cabinet body 1, and is located on the inner side of the second cabinet door 12. The second cabinet door 12 is not shown in FIG. 13, that is, the second cabinet door 12 is omitted in FIG. 13. The tray 10 may be located on the inner side of the first cabinet door 11, or may be located on the inner side of the first and second cabinet doors 11 and 12.

It should be noted that the inner side of the first and second cabinet doors 11 and 12 indicates a side of the first and second cabinet doors 11 and 12 close to the interior of the cabinet body 1. If the trays 10 are located on the inner side of the first and second cabinet doors 11 and 12, the number of trays 10 may be at least two, at least one tray 10 being located on the inner side of the first cabinet door 11 and at least one tray 10 being located on the inner side of the second cabinet door 12.

The tray 10 may be configured to mount a first device. When a cabinet door corresponding to the tray 10 is opened, the first device is exposed from the cabinet body 1 to enable maintenance of the first device. In this way, the maintenance of the first device is convenient, and there is no need to disassemble any structural parts, wiring harnesses, etc., which improves the maintainability of the electrical cabinet.

It should be noted that the cabinet door (the first cabinet door 11 and/or the second cabinet door 12) corresponding to the tray 10 can be closed when the first device does not require maintenance.

The first device on the tray 10 may include: a counter device and/or a power distribution circuit device. The power distribution circuit device may include a power distribution control panel, a temperature controller and the like, which is not limited in the embodiment. The first device on the tray 10 may further include other elements, which is not limited in the embodiment.

In order to improve the maintainability of the electrical cabinet, a second device may further be provided in the cabinet body 1, and located on the inner side of the tray 10. The outer side of the tray 10 faces the cabinet door corresponding to the tray 10, and the inner side of the tray 10 faces away from the cabinet door corresponding to the tray 10. The tray 10 is movably arranged in the cabinet body 1. When the cabinet door corresponding to the tray 10 is opened and the tray 10 is moved to a predetermined position, the second device is exposed from the cabinet body 1 to allow maintenance of the second device. In this way, the second device can be maintained by opening the corresponding cabinet door and removing the tray 10, without disassembling any structural component, wiring harness and the like, thereby improving the maintainability of the electrical cabinet.

In order to facilitate the maintenance of the second device, the tray 10 may be rotatably arranged in the cabinet body 1. For example, the tray 10 is rotatably arranged in the cabinet body 1 through a hinge.

The tray 10 may be arranged in the cabinet body 1 in such a manner as to be movable along a straight line or in any other manner, which is not limited to the above embodiments.

The second device includes a fan which is configured to drive the airflow in the heat dissipation air duct to flow.

It should be noted that, in a case that the electrical cabinet includes the third fan 5, the second device may include the third fan 5. As described above, the third fan 5 may be configured to drive the airflow in the heat dissipation air duct to flow. In a case that the electrical cabinet includes the fourth fan 7 and the fifth fan 8, the second device may include the fifth fan 8, and as described above, the fifth fan 8 may be configured to drive the airflow in the heat dissipation air duct to flow.

The second device may be selected as other devices. For example, the second device may include a voltage transformer and/or a lightning arrester, which is not limited in the embodiments of the present application.

In the electrical cabinet, the movement mode of the tray 10 and the components included in the second device may be combined arbitrarily. For example, the tray 10 is rotatably arranged in the cabinet body 1, and the second device includes the third fan 5 or the fifth fan 8, which facilitates the movement of the tray 10 and thus facilitates maintenance of the third fan 5 or the fifth fan 8.

It should be noted that, the tray 10 is configured to mount the first device, and the second device is arranged in the cabinet body 1, which can be carried out simultaneously, thus further improving the maintainability of the electrical cabinet. In an embodiment, the tray 10 is configured to mount the first device, and the second device is arranged in the cabinet body 1, which can be carried out separately. It is not limited in the embodiment.

As mentioned above, the heat exchanger 2 may be arranged on the first or second cabinet door 11 or 12. For the convenience of installation, one of the tray 10 and the heat exchanger 2 may be arranged on the first cabinet door 11, and the other of the tray 10 and the heat exchanger 2 may be arranged on the second cabinet door 12.

Based on the electrical cabinet according to the above embodiments, a photovoltaic power generation system is also provided according to the present application, which includes the electrical cabinet described above.

The electrical cabinet is connected to an inverter and a transformer. The electric energy of the inverter are combined by the electrical cabinet and transmitted to the transformer.

The electrical cabinet may be a combiner cabinet or of other type, which is not limited in the embodiments of the present application.

Since the electrical cabinet according to the embodiments has the above technical effects and the photovoltaic power generation system includes the electrical cabinet described above, the photovoltaic power generation system also has corresponding technical effects, which are not repeated herein.

The technical features mentioned above and the technical features shown separately in the drawings may be combined with each other arbitrarily, as long as the combined technical features are not contradictory to each other. All feasible feature combinations are technical contents clearly recorded herein. Any of the multiple sub features contained in the same sentence may be applied independently, and is not necessarily applied together with other sub features.

The above description of the embodiments enables those skilled in the art to implement or use the present application. Various modifications to the embodiments are apparent to those skilled in the art, and the general principles defined herein can be implemented in other embodiments without departing from the spirit or scope of the present application. Therefore, the present application is not limited to the embodiments shown herein, but conforms to the widest scope consistent with the principles and novel features disclosed herein.

## Claims

1. An electrical cabinet, comprising a cabinet body and a heat exchanger; wherein
the cabinet body is provided with a first switch area and a second switch area, which are distributed on adjacent sides of the cabinet body, the first switch area is provided with switches distributed along a first direction, the second switch area is provided with switches distributed along a second direction perpendicular to the first direction; and
the first switch area and the second switch area are located in a heat dissipation air duct of the cabinet body, and are distributed along an airflow direction in the heat dissipation air duct; and the heat exchanger is configured to exchange heat with the heat dissipation air duct.

2. The electrical cabinet according to claim 1, wherein the switches in the first switch area and the switches in the second switch area are distributed in an L shape.

3. The electrical cabinet according to claim 2, wherein the heat dissipation air duct is configured to allow airflow to flow through the first switch area along the second direction, and flow through the second switch area along the first direction.

4. The electrical cabinet according to claim 3, wherein the heat exchanger comprises a first heat exchange channel and a second heat exchange channel that are configured to exchange heat with each other, and the heat dissipation air duct and the second heat exchange channel are communicated end to end to form an inner circulation air duct;
the heat dissipation air duct comprises a first heat dissipation air duct, a second heat dissipation air duct, a third heat dissipation air duct, and a fourth heat dissipation air duct;
the first heat dissipation air duct, the second heat dissipation air duct, the third heat dissipation air duct, the fourth heat dissipation air duct, and the second heat exchange channel are communicated end to end in sequence; or the third heat dissipation air duct, the second heat dissipation air duct, the first heat dissipation air duct, the fourth heat dissipation air duct, and the second heat exchange channel are communicated end to end in sequence; and
the first switch area is located in the first heat dissipation air duct arranged along the second direction; and the second switch area is located in the third heat dissipation air duct arranged along the first direction.

5. The electrical cabinet according to claim 4, wherein
the electrical cabinet further comprises a first fan which is configured to drive the airflow to flow from the first switch area to the second switch area, or flow from the second switch area to the first switch area, and preferably, the first fan is arranged in the second heat dissipation air duct; and/or,
the heat exchanger further comprises a second fan which is configured to drive the airflow to flow from the fourth heat dissipation air duct to the second heat exchange channel, or flow from the second heat exchange channel to the fourth heat dissipation air duct.

6. The electrical cabinet according to claim 4, wherein the fourth heat dissipation air duct comprises a first heat-dissipation-air-duct section and a second heat-dissipation-air-duct section in communication with the first heat-dissipation-air-duct section; wherein
the first heat-dissipation-air-duct section and the second heat exchange channel are arranged in parallel, and the second heat dissipation air duct and the second heat-dissipation-air-duct section are arranged in parallel; and optionally
wherein the electrical cabinet further comprises a third fan which is configured to drive the airflow to flow from the first heat-dissipation-air-duct section to the second heat-dissipation-air-duct section, or flow from the second heat-dissipation-air-duct section to the first heat-dissipation-air-duct section.

7. The electrical cabinet according to claim 1, wherein the switches in the first switch area and the switches in the second switch area are distributed in a T shape.

8. The electrical cabinet according to claim 7, wherein the heat dissipation air duct is configured to allow airflow to flow through the first switch area and the second switch area in the second direction.

9. The electrical cabinet according to claim 8, wherein the heat exchanger comprises a first heat exchange channel and a second heat exchange channel that are configured to exchange heat with each other, and the heat dissipation air duct and the second heat exchange channel are communicated end to end to form an inner circulation air duct;
the heat dissipation air duct comprises: a sixth heat dissipation air duct, a seventh heat dissipation air duct, and an eighth heat dissipation air duct;
the sixth heat dissipation air duct, the seventh heat dissipation air duct, the eighth heat dissipation air duct, and the second heat exchange channel are communicated end to end in sequence; and
the first switch area and the second switch area are located in the sixth heat dissipation air duct, the sixth heat dissipation air duct and the eighth heat dissipation air duct are arranged along the second direction and distributed in parallel, and the seventh heat dissipation air duct and the second heat exchange channel are distributed in parallel.

10. The electrical cabinet according to claim 9, wherein
the electrical cabinet further comprises a fourth fan which is configured to drive the airflow to flow from the sixth heat dissipation air duct to the seventh heat dissipation air duct, or flow from the seventh heat dissipation air duct to the sixth heat dissipation air duct; and/or
the electrical cabinet further comprises a fifth fan which is configured to drive the airflow to flow from the seventh heat dissipation air duct to the eighth heat dissipation air duct, or flow from the eighth heat dissipation air duct to the seventh heat dissipation air duct; and/or
the heat exchanger further comprises a second fan which is configured to drive the airflow to flow from the eighth heat dissipation air duct to the second heat exchange channel, or flow from the second heat exchange channel to the eighth heat dissipation air duct.

11. The electrical cabinet according to claim 1, wherein the heat exchanger comprises a first heat exchange channel and a second heat exchange channel that are configured to exchange heat with each other, wherein the heat dissipation air duct and the second heat exchange channel are communicated end to end to form an inner circulation air duct.

12. The electrical cabinet according to claim 11, wherein
a heat dissipation inlet and a heat dissipation outlet of the heat dissipation air duct, and the heat exchanger are distributed on the same side of the cabinet body; and/or
the heat dissipation inlet of the heat dissipation air duct faces the first switch area or the second switch area; and/or
a first cabinet door is provided on a side of the cabinet body that is provided with the first switch area, and a second cabinet door is provided on a side of the cabinet body that is provided with the second switch area; and the heat exchanger is arranged at the first cabinet door or the second cabinet door; and/or
both an inlet and an outlet of the first heat exchange channel are in communication with an external environment of the cabinet body; and the heat exchanger further comprises a sixth fan which is configured to drive air of the external environment to flow through the first heat exchange channel.

13. The electrical cabinet according to any one of claims 1 to 12, wherein
the cabinet body is also provided with a circuit breaker area and a power distribution area, wherein the circuit breaker area and the first switch area are located on the same side of the cabinet body, the power distribution area and the second switch area are located on the same side of the cabinet body, and both the circuit breaker area and the power distribution area are located in the heat dissipation air duct; and/or
the cabinet body is also provided with a first wiring area and a second wiring area; wherein the first wiring area and the first switch area are located on the same side of the cabinet body and are adjacently arranged; and the second wiring area and the second switch area are located on the same side of the cabinet body and are adjacently arranged.

14. The electrical cabinet according to claim 13, wherein the first switch area, the second switch area, the power distribution area, and the circuit breaker area are sequentially distributed along the airflow direction; or the circuit breaker area, the power distribution area, the second switch area, and the first switch area are sequentially distributed along the airflow direction.

15. The electrical cabinet according to any one of claims 1 to 12, wherein in a case that a first cabinet door is provided on a side of the cabinet body that is provided with the first switch area, and a second cabinet door is provided on a side of the cabinet body that is provided with the second switch area, a tray is provided in the cabinet body, and is located on an inner side of at least one of the first cabinet door and the second cabinet door;
the tray is configured to mount thereon a first device which is exposed from the cabinet body to enable maintenance of the first device when the cabinet door corresponding to the tray is opened; and/or
a second device is provided in the cabinet body located on an inner side of the tray, and the tray is movably arranged in the cabinet body, so that the second device is exposed from the cabinet body to enable maintenance of the second device when the cabinet door corresponding to the tray is opened and the tray is moved to a predetermined position.

16. The electrical cabinet according to claim 15, wherein
the tray is rotatably arranged in the cabinet body; and/or
the second device comprises a third fan configured to drive the airflow in the heat dissipation air duct to flow or a fifth fan configured to drive the airflow in the heat dissipation air duct to flow.

17. A photovoltaic power generation system, comprising the electrical cabinet according to any one of claims 1 to 16.
